(19) Europäisches Patentamt

European Patent Office

Office européen des brevets

(11) **EP 1 212 838 B1**

(12) **EUROPEAN PATENT SPECIFICATION**

(45) Date of publication and mention
of the grant of the patent:
**29.01.2003 Bulletin 2003/05**

(51) Int Cl.⁷: $H03M\ 3/02$, $H03D\ 7/16$

(21) Application number: **00944647.7**

(86) International application number:
**PCT/US00/16076**

(22) Date of filing: **12.06.2000**

(87) International publication number:
**WO 01/011786 (15.02.2001 Gazette 2001/07)**

(54) **HYBRID BANDPASS AND BASEBAND DELTA-SIGMA MODULATOR**

HYBRIDER DURCHLASSBAND UND BASISBAND DELTA-SIGMA MODULATOR

MODULATEUR DELTA-SIGMA HYBRIDE A BANDE DE BASE ET BANDE PASSANTE

(84) Designated Contracting States:
**DE FR GB IT NL**

(30) Priority: **09.08.1999 US 370597**

(43) Date of publication of application:
**12.06.2002 Bulletin 2002/24**

(73) Proprietor: **ATMEL CORPORATION
San Jose, California 95131 (US)**

(72) Inventor: **MORIN, Marc, A.
Woodland Park, CO 80863 (US)**

(74) Representative: **Käck, Jürgen
Kahler Käck Mollekopf
Vorderer Anger 239
86899 Landsberg (DE)**

(56) References cited:
**CA-A- 2 157 690**

• **YASUDA A ET AL: "BANDPASS D-S
MODULATOR WITH FREQUENCY
CONVERTERS IN FEEDBACK LOOP"
ELECTRONICS LETTERS,GB,IEE STEVENAGE,
vol. 34, no. 24, 26 November 1998 (1998-11-26),
pages 2293-2295, XP000871269 ISSN: 0013-5194**

**Description**

TECHNICAL FIELD

This invention relates generally to digital encoding of electrical signals, and more specifically to a delta-sigma modulator.

BACKGROUND ART

It is desirable to digitize bandpass signals, i.e. radio frequency (RF) or acoustic signals, as near to the source, such as an antenna or transducer, as possible with a high degree of accuracy, and to implement the analog-to-digital (A/D) conversion on integrated circuits in order to make use of the advantages of CMOS digital signal processing technology. The delta-sigma modulator has become a common architecture to implement analog-to-digital conversion because high levels of accuracy can be achieved, such as greater than 10 bits, without the need for high tolerance components.

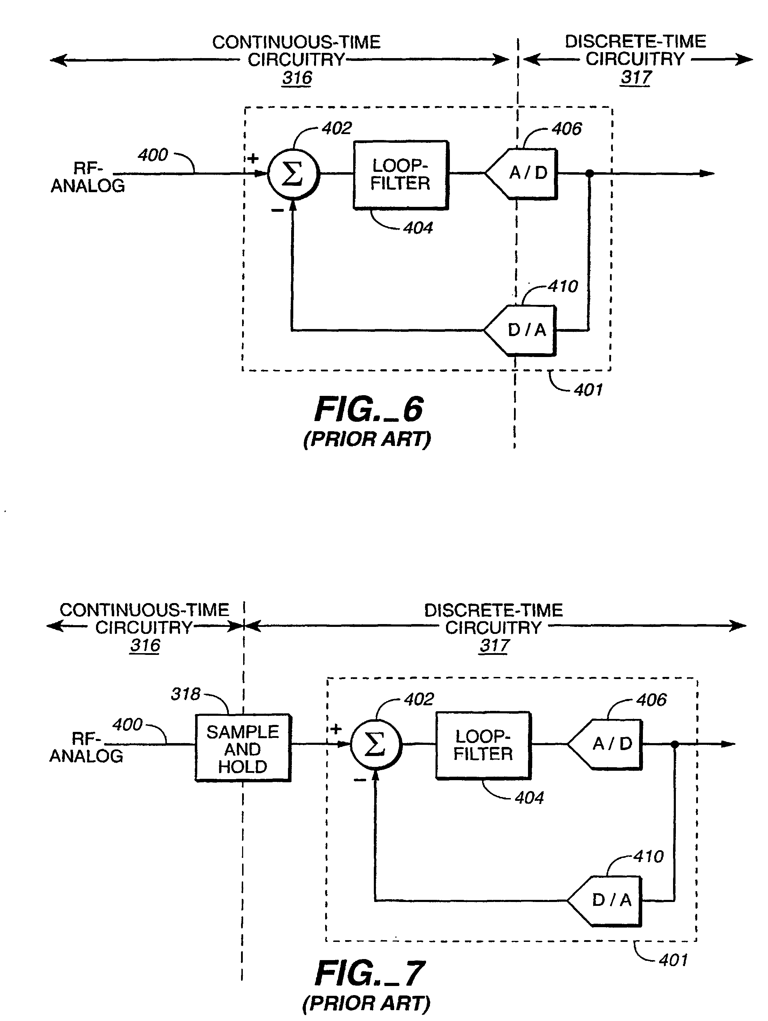

Although delta-sigma modulators are often implemented as a discrete-time system, there is another class of delta-sigma modulators, of which the present invention is included, that operates as a continuous-time system. With reference to Fig. 6, in a continuous-time modulator, the time-sampling operation takes place within the analog-to-digital conversion element 406 within the modulator loop 401. Thus, a portion of the modulator loop 401, including the loop filter 404 operates as continuous-time 316 circuitry, rather than discrete-time circuitry 317. This is opposed to a discrete-time modulator, as shown in Fig. 7, wherein the time-sampling operation takes place before the modulator 401 in a sample-and-hold circuit 318. Thus, in a discrete-time system, the entire modulator loop operates as discrete-time circuitry 317. However, pushing the time-sampling operation into the noise-shaping loop, as in Fig. 6, results in a much higher speed of operation of the modulator and consequently much wider bandwidths can be digitally converted. Therefore, although the present invention could be implemented to operate as a discrete-time system for lower frequency applications, it is preferred that the present invention be implemented as a continuous-time system.

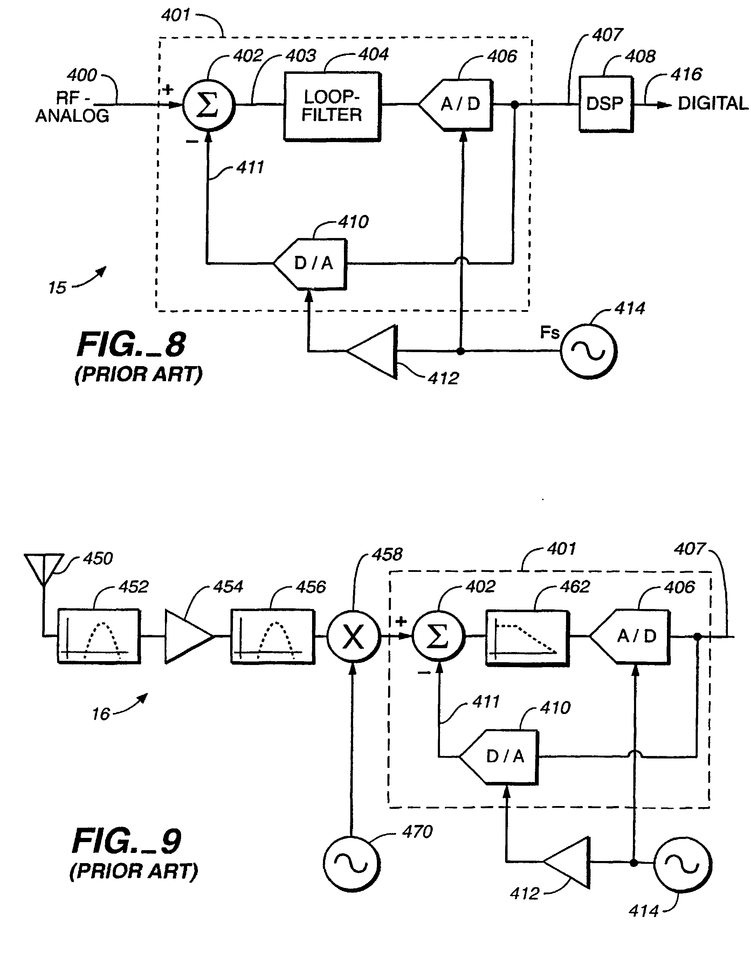

The generalized architecture of a continuous-time delta-sigma A/D converter 15 is shown in Fig. 8. The delta-sigma A/D converter 15 receives an analog signal 400 at the input and the analog signal is supplied to a delta-sigma modulator circuit 401. The signal 400 is differenced with a feedback signal 411 at an input delta junction 402 to form an error signal 403. The resulting error signal 403 is then processed by a loop filter 404, which is typically implemented as an integrator or a series of integrators, and thus implements the sigma function. The loop filter 404 provides noise shaping of the quantization noise introduced by the A/D converter 406 in the loop, and thus results in a very high precision signal conversion. The loop filter 404 can be quite complicated in that it can contain multiple feedback paths from the digital-to-analog converter 410 and possibly also can contain feed-forward paths. The loop filter 404 implements either a low pass or a bandpass function. In the case of a low pass function, the resulting modulator is referred to as a baseband delta-sigma modulator. In the case of a bandpass function, the modulator is referred to as a bandpass delta-sigma modulator, and this type of filter is often implemented with resonators. The output of the loop filter 404 is sampled with a low-bit, typically 1-4 bit, A/D converter 406. The output 407 of the A/D converter 406 is fed back to the input delta junction 402 through a digital-to-analog (D/A) converter 410, and is also supplied to digital signal processing (DSP) circuitry 408 to recover a high-precision digital signal at the output 416. A sampling clock 414 provides timing signals for the A/D 406 and D/A 410 converters, and an amplifier 412 buffers or delays the clock signal that is supplied to the D/A converter 410.

In the past, delta-sigma architectures have been applied to audio signals. However, with the increase in speed of semiconductor technology, delta-sigma architectures are presently being applied to radio frequency (RF) signals and the standard analog RF signal processing chain is being replaced by digital circuitry. The A/D converter has been the limiting technology in this progression and recently efforts have been made to improve this technology. Several delta-sigma modulators sampling above IGHz have been published, although the precision of these devices is still less than adequate for most RF systems.

With reference to Fig. 9, a typical baseband delta-sigma modulator 401 is shown with the application of the delta-sigma modulator being in a RF downconverter chain 16 using a low intermediate frequency (IF) conversion scheme. In Fig. 9, portions of the circuit identical to that shown in Fig. 8 are referred to by common element numbers, with explanation thereof being omitted. The loop filter within the modulator 401 is shown to be a low-pass filter 462. Using a single baseband delta-sigma modulator requires expensive image rejection filtering 452, 456 before the mixing. The reason that the additional filtering is required is that in a typical baseband modulator, the opposite sideband needs to be suppressed or else it will leak across into the desired sideband and will corrupt the signal. The filter required to suppress the opposite sideband is typically quite expensive and it is not typically possible to integrate the filter on chip. In Fig. 9, this additional filtering is shown to be prior to the delta sigma modulator 401, as the signal is received at input antenna 450 and proceeds through a first bandpass filter 452, an amplifier 454, and then a second bandpass filter 456, the output signal of the second bandpass filter 456 being frequency translated with a downconversion mixer 458 with a signal from a local oscillator 470.

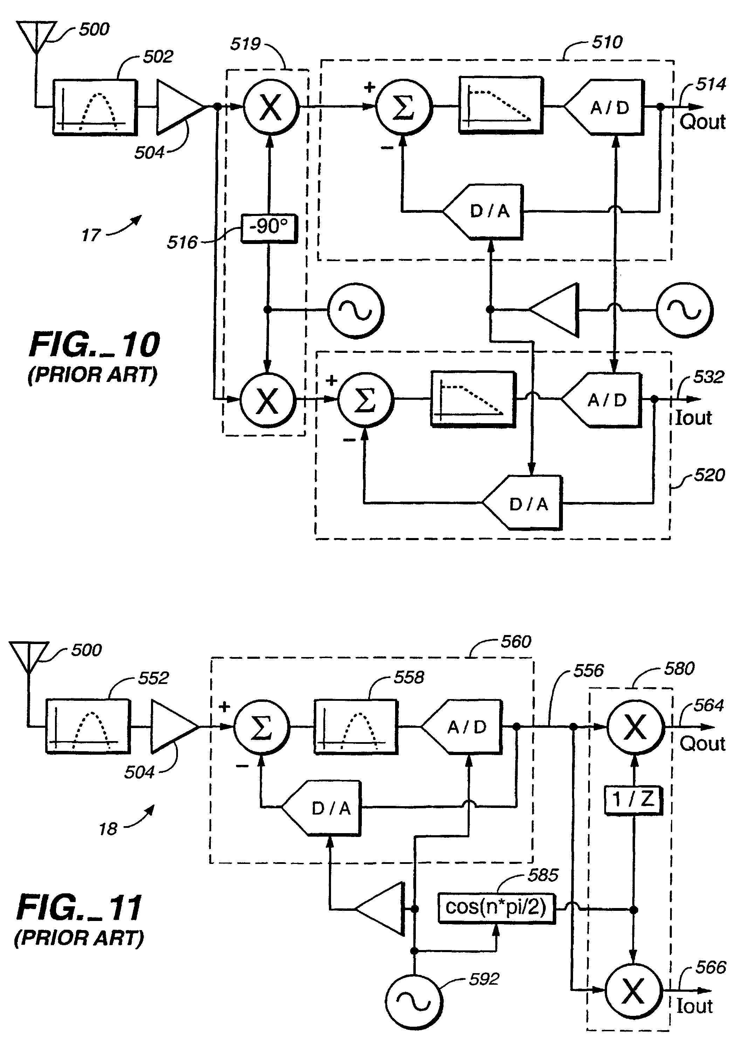

An alternate RF downconversion scheme using two baseband delta-sigma modulators is an image rejection architecture 17, shown in Fig. 10. After the RF input signal proceeds from the input antenna 500 through pre-filtering 502 and amplification 504, a quadrature, single-sideband image rejection mixer 519 is used to create in-phase (I) and quadrature (Q) channels of a complex baseband or low IF signal. These channels are sampled by two synchronous baseband delta-sigma modulators 510, 520 to produce output Q and I signals 514, 532 which are sent to a digital signal processor (not shown) for signal recovery. The leakage of one sideband into the other sideband is determined by the phase error of the -90 degree offset circuit 516 and by any magnitude or phase deviation in the analog circuitry between the two channels, Q and I. In the present state of semiconductor processing, it is possible to attain about -30 dB sideband leakage. This reduces the pre-filter image rejection requirements by 30 dB. (It is also possible to implement a direct conversion architecture, where the local oscillator is placed in the center of the band, but the signal conversion precision is then limited to approximately 30 dB.)

A third common architecture utilizes a bandpass delta-sigma modulator 560 in an RF downconverter chain 18, as shown in Fig. 11. The architecture is similar to the baseband architecture shown in Fig. 9, except that in the loop filter 558, the low-pass filter has been replaced by a bandpass filter. This facilitates direct sampling of the RF signal without analog downconversion mixing. The output 556 of the delta-sigma modulator 560 is supplied to a digital downconverter mixer 580 to create the Q and I channels, 564, 566 of the baseband signal. The local oscillator, represented by function block 585, typically operates at ¼ of the frequency of the sample clock 592. The output Q and I channels 564, 566 are then passed to a digital signal processor to recover the digital signal. This architecture has the advantage of requiring only a low quality bandpass filter 552 before the data converter and some amplification 504.

In the digital downconverter mixer circuit 580, the local oscillator performs the function (cos 2Πft), represented by block 585, where f is frequency of the local oscillator and t is time. In the sampled time domain, the value t can be replaced by the value n/fs, where n is the sample number and fs is the sample clock rate. It is generally desired to maintain the local oscillator rate at ¼ of the frequency of the sample clock. The reason for this is to provide a simpler implementation of the mixer, which will become evident below. When the local oscillator rate is maintained at ¼ of the sample rate, the value f can be replaced by the value fs/4, where fs is the sample rate. This produces the function $(\cos 2\Pi \frac{fs\,n}{4\,fs})$, which can be reduced to $(\cos \frac{\Pi n}{2}$ Substituting the value 0 for the sample number, n, produces (cos 0) which equals 1. When n = 1, the function is $(\cos \frac{\Pi}{2})$, which equals 0. When n = 2, the function is (cos Π); which equals -1, and when n = 3, the function is $(\cos \frac{3\Pi}{2})$ which equals 0. This pattern of 1, 0, -1, 0 repeats for subsequent values of n, and since the values 0, 1 and -1 are perfectly represented by 2 bits, a simple implementation of the mixer results. The majority of bandpass delta-sigma modulators are designed so that the digital local oscillator operates at ¼ of the sample rate.

Although wideband bandpass delta-sigma modulators have been built with sample rates near or over 1 GHz, their performance has been limited to near 60 dB dynamic range with approximately 25 MHz of bandwidth. However, some applications require over 100 dB of dynamic range and there are some physical problems with implementing such a structure in a production environment. First, the loop filter is quite complicated and requires several tuning circuits to achieve the required center frequency and quality-factor of the resonator. Second, the tolerable loop delay is much less than that of a baseband modulator. Loop delay is the time that it takes for the A/D converter in the loop circuit to be clocked, for the data to settle, and for the data to be latched back to the input by the D/A converter. Phase margin in the loop circuit is achieved by adjusting the unity gain frequency of the integrators. By lowering the unity gain frequency, more phase margin can be achieved. With more phase margin, more loop delay is tolerable. It is possible to have up to 1/(2Fs) loop delay in baseband modulators, where Fs is the frequency of the sample clock. However, in bandpass modulators, it is very difficult to stabilize the modulators with even 1/(10Fs) loop delay because these devices lack the integrators used to control stability. For example, assuming the bandpass filter is operating at ¼ of the sample-rate, to directly sample an RF signal at 1GHz, would require a 4GHz clock rate and a bandpass loop filter at 1GHz. Using a 1/(10Fs) loop delay requirement, a 4GHz sample clock would need a loop delay of less than 25psec, which is nearly impossible in today's technology. Going to higher frequencies presents even more of a problem.

Various attempts to improve the recovery of IF and RF bandpass signals using delta-sigma modulators are reported in the art. U.S. Patent No. 4,857,928 to Gailus et al., for example, explains that when a mixer is used to move the bandpass signal down to the baseband range before applying it to a delta-sigma A/D converter, it becomes difficult to distinguish between a desired 0 Hz component of the signal and an undesired DC offset acquired attached to the signal. To accommodate for this, Gailus et al. have their mixer output fed to a continuous-time delta-sigma modulator that includes an additional DC correction circuit in its feedback path. Their delta-sigma modulator receives the output from the mixer; filters the signal and then subtracts the DC component from the previous sample before applying the result to a quantizer.

U.S. Patent No. 4,888,557 to Puckette, IV et al. explains that another limitation of using delta-sigma modulation is that the A/D converter typically needs to function at four times the target signal's frequency. Puckette, IV et al. explain that this high clock rate can be reduced to 4f/2n+1, where f is the target signal's frequency and n is an integer 0, 1, 2, etc., as long as n does not introduce spectral aliasing.

U.S. Patent No. 5,729,230 to Jensen et al. shows a delta-sigma modulator suitable for operation with signals up to 1 GHz. Jensen et al. apply a received signal to a voltage-to-current converter and construct a current-based delta-sigma converter. A received signal is applied to a tunable resonator, the output of the resonator is applied to a quantizer, and the output of the quantizer is applied to a D/A converter before being fed back to the input. By implementing a tunable resonator, their delta-sigma modulator can function as both a bandpass AID converter and a baseband AID converter.

U.S. Patent No. 5,734,683 to Hulkko et al. shows a structure for adapting a baseband delta-sigma converter for use with intermediate frequency signals. This, Hulkko et al. explain, makes them suitable for radio telephone applications. Hulkko et al. use switched capacitor switching elements to implement both a mixer and an automatic gain control circuit, which reportedly reduces the number of components required.

It is an object of the present invention to provide a delta-sigma modulator that combines the beneficial features of baseband delta-sigma modulators with the beneficial features of bandpass delta-sigma modulators, to result in a modulator that includes simpler loop filters with more tolerable loop delay and that does not require expensive pre-filtering.

It is a further object of the present invention to provide a delta-sigma modulator having lower power consumption, reduced A/D converter clock speed and simple clock decimation schemes.

## SUMMARY OF THE INVENTION

The above objects have been met by a delta-sigma modulator having a downconverter mixer circuit in the forward path of the modulator and an upconverter mixer circuit in the feedback path of the modulator. The modulator consists of a loop filter having two components, a bandpass filter before the downconverter mixer and a low-pass filter after the downconverter mixer. The mixer circuits can be implemented as single-sideband mixers with in-phase and quadrature paths. In such a modulator, the loop filter component after the quadrature mixer contains two low-pass filters, one for the in-phase path and another for the quadrature path. The feedback also has two paths, which are recombined in the upconverter mixer circuit and produces a real, analog signal to be fed back to the input. A large number of arrangements of this type of modulator exist including arrangements with multiple intermediate feedback paths to both the baseband loop filter and the bandpass loop filter sections. Additionally, this modulator can be implemented in a cascade type structure using known methods. The digital output of the modulator's ADC(s) represent a baseband signal and it is decimated with digital signal processing as in conventional delta-sigma modulator configurations.

Thus, the resulting hybrid bandpass and baseband delta-sigma modulator of the present invention provides some of the benefits of a bandpass delta-sigma modulator, such as simpler pre-filtering, and some of the benefits of a baseband delta-sigma modulator, such as excessive loop delay compensation. Other advantages provided by the present invention include low power consumption and improved image rejection. Low power consumption is attained by only requiring one high current stage for linearity, similar to a bandpass delta-sigma modulator. In contrast, the quadrature baseband arrangement of the prior art, shown in Fig. 10, requires two high current mixers and two high current delta-sigma input stages. In the arrangement of the present invention, the linearity requirements of the mixers inside the loop are reduced by approximately the gain provided by the first part of the loop filter over the bandwidth of interest. The improved image rejection of this invention is achieved by moving the mixing operation into the loop. The gain and phase mismatch errors between the quadrature paths of the loop are operating primarily on the quantization noise and not the signal, and therefore the mismatch error effects are reduced. This further works to reduce the requirements of the pre-filter.

## BRIEF DESCRIPTION OF THE DRAWINGS

Fig. 1 is a block diagram of a double-sideband hybrid bandpass and baseband delta-sigma modulator embodiment of the present invention.

Fig. 2 is a block diagram of a single-sideband hybrid bandpass and baseband delta-sigma modulator embodiment of the present invention.

Fig. 3 is a block diagram of the embodiment of Fig. 2 having reduced sample-rate circuitry.

Fig. 4 is a first implementation of the embodiment of the invention of Fig. 3.

Fig. 5 is a second implementation of the embodiment of the invention of Fig. 3.

Fig. 6 is a block diagram of a continuous-time delta-signal modulator, as known in the prior art.

Fig. 7 is a block diagram of a discrete-time delta-signal modulator, as known in the prior art.

Fig. 8 is a block diagram of a general delta-sigma A/D conversion architecture, as known in the prior art.

Fig. 9 is a block diagram of RF receive systems using a baseband delta-sigma modulator, as known in the prior art.

Fig. 10 is a block diagram of RF receive systems using an image-rejection delta-sigma modulator, as known in the prior art.

Fig. 11 is a block diagram of RF receive systems using a bandpass delta-sigma modulator as known in the prior art.

## BEST MODE FOR CARRYING OUT THE INVENTION

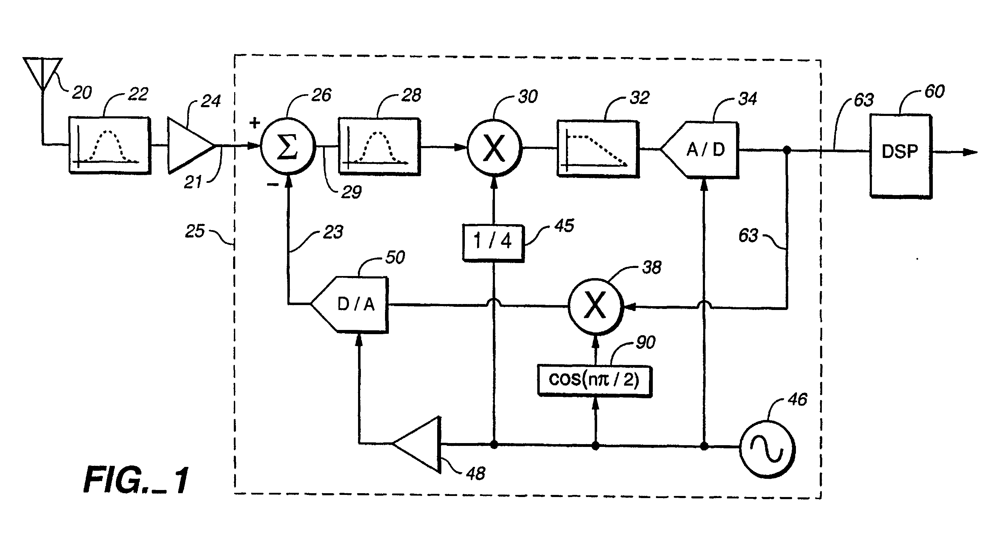

With reference to Fig. 1, a first embodiment of the present invention is a double-sideband hybrid bandpass and baseband delta-sigma modulator 25. The double-sideband modulator includes a downconverter mixer circuit 30 in the forward path and an upconverter mixer circuit 38 in the feedback path. An input RF signal is received at an antenna 20 and proceeds through some pre-filtering circuitry 22 and low noise amplification 24 before being input to the modulator. The first circuit of the modulator 25 is an input delta junction 26 wherein the input signal 21 is differenced with the feedback signal 23 to create the error signal 29. The error signal 29 is supplied to a bandpass noise-shaping filter 28 and then to a downconverter mixer 30 where the signal is mixed with a signal from a local oscillator circuit. The local oscillator 45 operates at ¼ the sample clock frequency. Since this is a double-sideband mixer, a low IF is required with extensive pre-filtering 22 to eliminate the opposite sideband at RF. The signal from the downconverter mixer 30 is then integrated through a low-pass noise-shaping filter 32 producing high precision low IF signal. The signal is then quantized with an A/D converter 34 which produces a digital signal 63, and is supplied to a digital signal processor 60 for decimation and signal recovery. The digital signal 63 is also fed back to an upconverter mixer 38 in the feedback path wherein the signal is mixed with a signal from a second local oscillator 90, implemented as the sequence [1, 0 - 1, 0] as previously described. The upconverter mixer 38 produces a signal that is then supplied to a digital-to-analog converter 50. The analog output of the digital-to-analog converter 50 is the feedback signal 23 that is supplied back to the input delta junction 26.

A sampling clock 46 provides the timing signals for the modulator 25, the clock signals being supplied to the A/D converter 34, and to the D/A converter 50 after buffering 48. The analog local oscillator for mixer 30 is derived from a divide-by-four circuit 45 off of the sample clock 46. The digital local oscillator for mixer 38 is implemented with the function ($\cos n\frac{\Pi}{2}$), block 90, also operating at ¼ of the frequency of the sampling clock. As explained previously, it is generally desired to have the local oscillator operate at ¼ of the sample rate in order to provide a simpler implementation of the mixer circuits. However, other frequencies can also be used for the frequency of the local oscillators, depending on the particular application. The analog-to-digital converter 34 and the D/A converter 50 clock at the full rate of the clock.

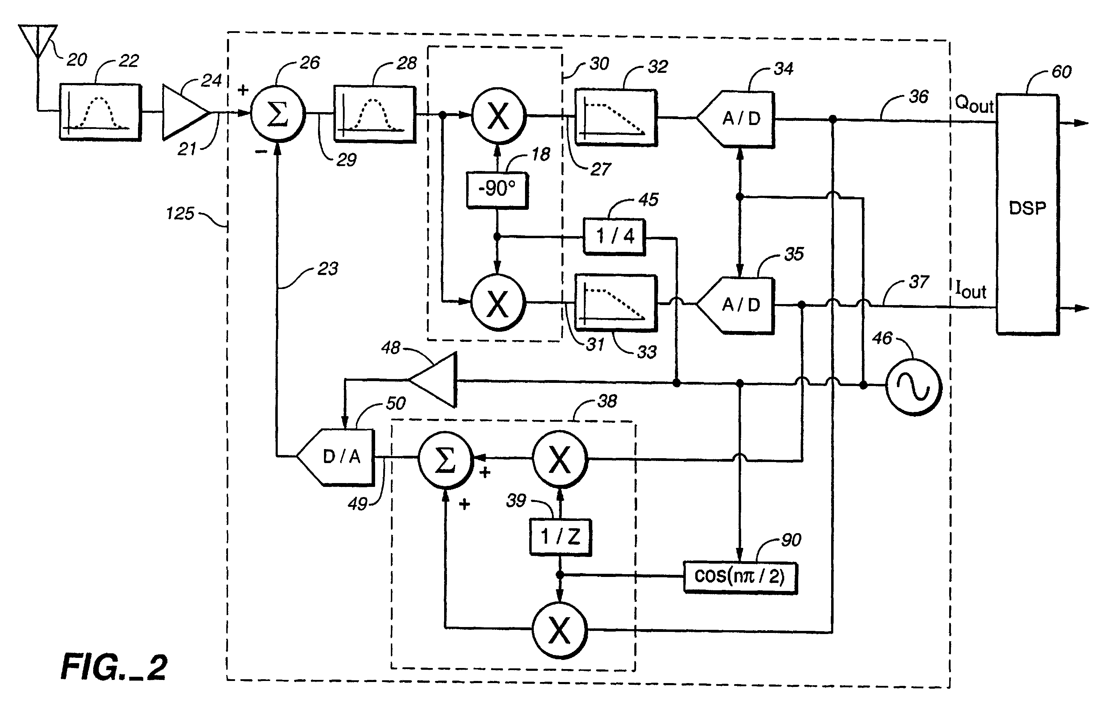

With reference to Fig. 2, a second embodiment of the present invention is a single-sideband hybrid bandpass and baseband delta-sigma modulator 125. As in the double-sideband embodiment of Fig. 1, prior to the modulator 125, an input RF signal is received at an antenna 20 and proceeds through some pre-filtering circuitry 22 and a pre-amplifier 24 before being input to the modulator 125. However, the pre-filtering requirements are not as stringent as required for the double side-band embodiment of Fig. 1. The first circuit of the modulator 125 is an input delta junction 26 wherein the input signal 21 is differenced with the feedback signal 23 to create the error signal 29. The error signal 29 is supplied to a bandpass filter 28. Then, the output of the bandpass filter 28 is supplied to a downconverter mixer 30 which converts the signal to a low IF creating a complex signal consisting of quadrature (Q) 27 and in-phase (I) 31 channels. Each of these channels is processed through a low-pass filter 32, 33 and an analog-to-digital converter 34, 35. The resulting output channels, Qout 36 and Iout 37, are then supplied to a digital signal processor 60 for decimation filtering and signal recovery. The output channels Qout 36 and Iout 37 are also fed back to the quadrature upconverter mixer 38 located in the feedback path which upconverts the complex digital low IF channels to a digital bandpass signal. From the output 49 of the quadrature upconverter mixer 38, the digital bandpass signal is then supplied to a digital-to-analog converter 50 which converts the digital bandpass signal to an analog bandpass feedback signal 23 which is supplied back to the input delta junction 26.

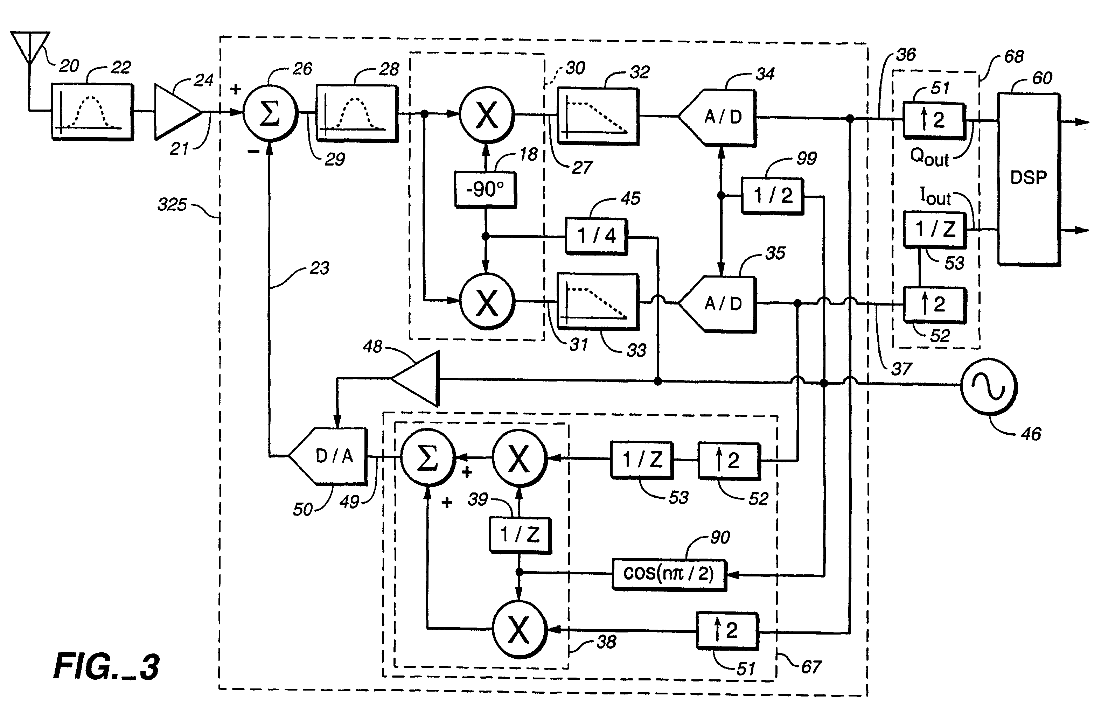

Referring to Fig. 3, the single-sideband modulator embodiment of Fig. 2 is shown with the reduced sample-rate circuitry. In the modulator 325 of Fig. 3, the analog-to-digital converters 34 and 35 clock at half the rate of the master clock while the D/A converter clocks at the full rate of the master clock. This reduction in sample rate is possible when the local oscillators operate at ¼ the sample clock frequency. As previously mentioned, the sequences of the digital local oscillators are [1, 0, -1, 0] in the I channel and [0, 1, 0, -1] in the Q channel. Thus, the output of the upconverter mixer in Fig. 3 is [Iout (1) Qout (2), -Iout (3), -Qout (4), ...]. It is noted that every other sample in either channel is discarded. Thus, the sample rates of the A/D converter 34 and 35 may be reduced by a factor of two. These A/D converters can be sampled at different clock phases to produce the desired outputs [Iout (1), Iout (3), ...] and [Qout (2), Qout (4), ...] or can be sampled in phase and thus requiring the I channel to be appropriately delayed. This delay 53 must occur in the feedback path effectively after upsampling 52, as well as in the output path after modulator 325 and after upsampling 52. The upconversion feedback circuit 67 reduces to simple logic. The output path circuitry 68 can be absorbed into the DSP 60 without the cost of additional circuitry. The reduction in sample rate allows for advantages in implementation, such as lower power operation and/or faster overall speed of operation due to a longer allowable settling time of the A/D circuits.

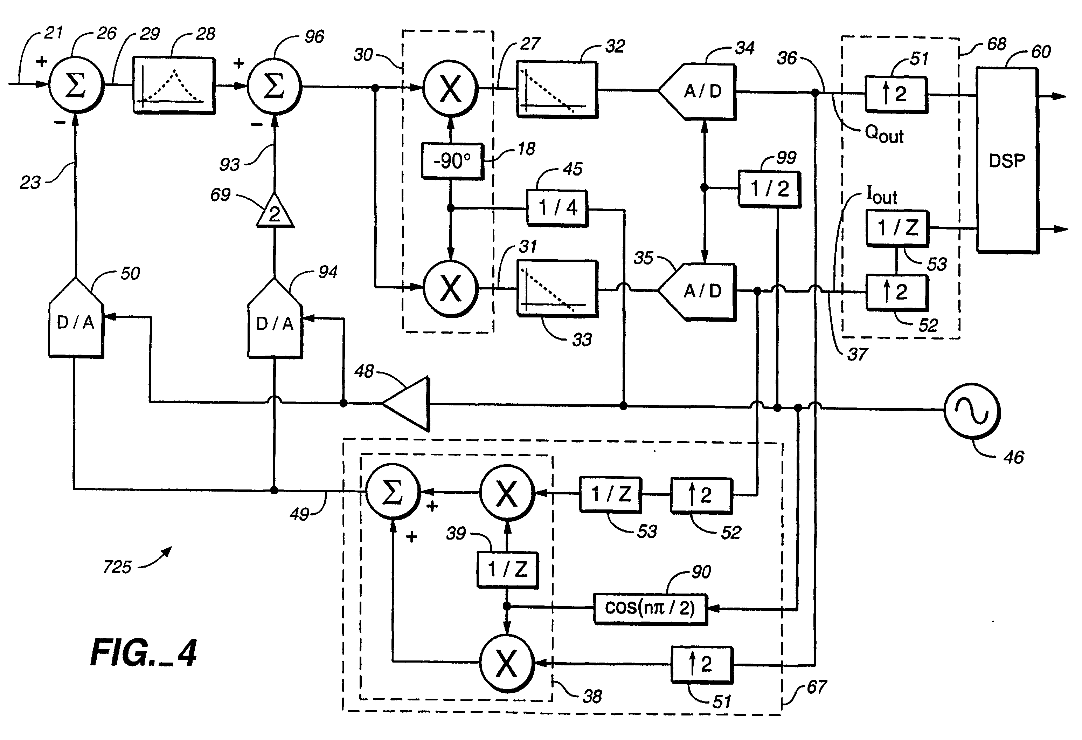

With reference to Fig. 4, an implementation of the embodiment of the invention shown in Fig. 3 is a third order single-sideband hybrid bandpass and baseband delta-sigma modulator 725. This modulator 725 has a resonator 28 and two feedback paths common to both loops. Then the loops are split into two channels 27 and 31 with an image rejection mixer 30. A separate integrator, 32 and 33, per channel 27 and 31 follows image rejection mixer 30 for further noise shaping and stability control. As in the previously described embodiments, the input signal 21 is supplied to the input delta junction 26 and is differenced with the feedback signal 23. The output 29 from the input delta junction 26 is supplied to a resonator 28 and is then differenced with a second feedback signal 93 from a second feedback loop at a second delta junction 96. The output of the delta junction 96 is supplied to a quadrature mixer 30 which performs downconversion to an intermediate frequency, IF, by mixing the signal with a signal from a local oscillator 45 with -90 degree phase offset 18 to produce the quadrature channel Q 27 and in-phase channel I 31 of the baseband signal. Quadrature mixer 30 may alternately downconvert its input signal to the baseband, but downconversion to a low IF is preferred since this avoids 0Hz components and reduces image rejection problems. The Q channel 27 is supplied to a first integrator 32 which implements a low-pass function and provides noise-shaping. The output of the integrator 32 is then supplied to an A/D converter 34 which converts the signal to digital baseband signal, Qout 36. The I channel loop operates in a similar manner to the Q channel loop, except that it operates 90 degrees out of phase from the Q channel. The I channel 31 is supplied to a second integrator 33 and then the signal is supplied to A/D converter 35 for conversion to a digital baseband signal, Iout 37. The digital baseband output channels Qout 36 and Iout 37 constitute the output of the modulator and are then supplied to reduced sample rate compensation circuitry 68 in the output path consisting of upsampling by two 51, 52, with a unit delay 53 in the I channel 37. Then, the channels are supplied to digital signal processing 60 for decimation. The channels are also supplied into the feedback path to the upconversion circuit 67 previously described. The output 49 of the upconversion circuit 67 is split into two feedback paths. One path is supplied through D/A converter 94 and gain element 69 to form feedback signal 93 at second delta junction 96, and the other path is supplied through D/A converter 50 to form feedback signal 23 at input delta junction 26.

The modulator 725 of Fig. 4 takes advantage of the power savings in the image reject mixer 30, which is attained by having the resonator 28 precede it. The center frequency of the resonator 28 can be virtually anywhere within the passband and its quality factor can be relatively low (10 to 25) as long as there is sufficient gain across the bandwidth of interest. This allows for plenty of variation of the resonator in manufacturing and in drifting over temperature and other environmental factors. The gain of the resonator reduces the required third order intercept point, IP3, of the mixers by approximately the gain in the resonator.

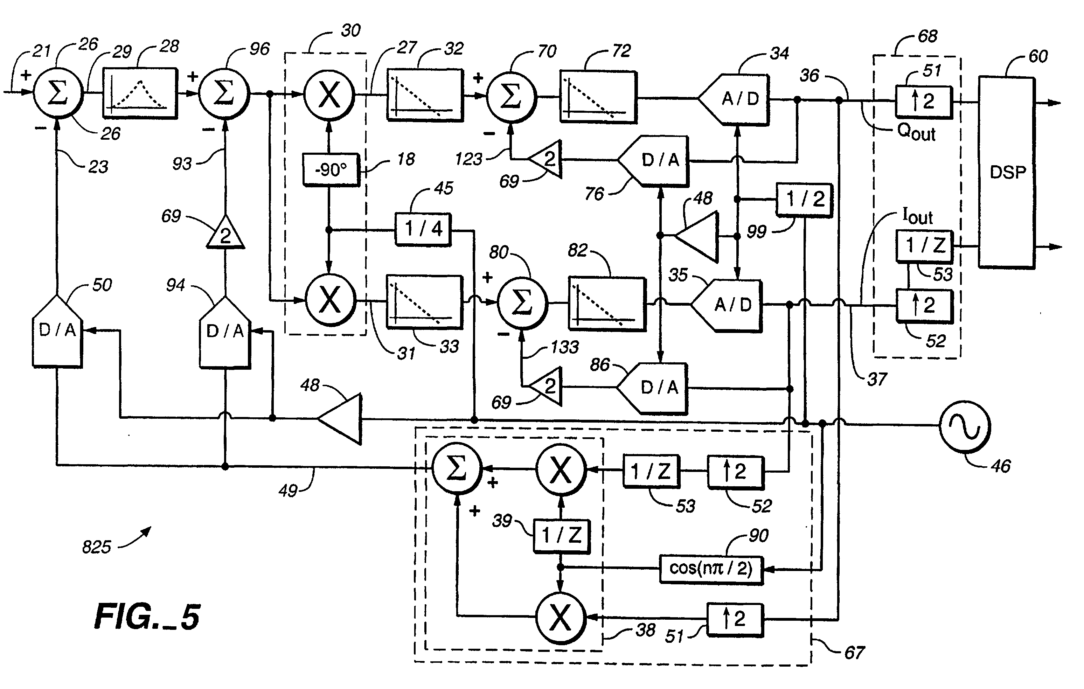

Another implementation, of the single side-band embodiment of the present invention is shown in Fig. 5, which is a fourth order single-sideband hybrid bandpass and baseband delta-sigma modulator 825. Typically, the higher order implementations of the invention provide better suppression of quantization noise, so therefore this implementation, being a fourth order circuit, would be the preferred embodiment of the invention. Alternatively, other implementations of the invention can be made to produce even higher order circuits, however these may be more difficult to stabilize. The modulator 825 of Fig. 5 is similar to the third order architecture of the modulator shown in Fig. 4, except that an extra integrator and an extra feedback path has been added in each loop. With reference to Fig. 5, after the input signal 21 is differenced with the feedback signal 23 at the input delta junction 26, the resulting signal 29 is supplied to a resonator 28. The output of the resonator 28 is differenced from a second feedback signal 93 at a second delta junction 96 and the output is supplied to mixer 30 which performs the downconversion to a low IF. The channels Q 27 and I 31, are supplied to a respective integrator 32, 33 for noise-shaping. Then the channels are provided to separate identical local feedback loops. Each channel is differenced with a respective, local feedback signal 123, 133 at a respective, local delta junction 70, 80 and their output is supplied to a respective second integrator 72, 82. A low pass response is provided by each pair of integrators 32, 72 and 33, 82, together with the feedback path. Each of the outputs of integrators 72 and 82 is supplied to a respective A/D converter 34, 35 to produce the digital baseband channels Qout 36 and Iout 37. Upsampling logic circuit 68 receives Iout and Qout channels 36, 37 and upsamples them by two 51, 52, with the I channel 37 having a unit delay 53. The outputs of upsampling logic circuit 68 are supplied to digital signal processor 60 for decimation. The modulator outputs 36, 37 are also fed back to the upconversion circuit 67 to produce a digital bandpass signal. The digital bandpass signal is supplied to a digital-to-analog converter 50, which provides the analog bandpass feedback signal 23. The digital bandpass signal is also supplied to the D/A converter 94 with gain element 69, which provides the analog bandpass feedback signal 93. Additionally, the output channels 36, 37 are supplied to local D/A converters 76, 86 with gain element 69 in each local feedback loop to provide the local feedback signals 123, 133 for each of the local feedback loops.

The improvement in performance in the fourth order single side-band hybrid architecture of Fig. 5 is to increase the bandwidth and/or improve the signal-to-noise and distortion ratio, SIND, for a given clock rate. Also, the spurious-free-dynamic-range (SFDR) improves as idle tones are further suppressed.

The hybrid bandpass and baseband delta-sigma modulator circuits of the present invention can be implemented in CMOS or BiCMOS technologies, with silicon germanium (SiGe) BiCMOS as the preferred technology for application to VHF, L, and S-band communications and radar systems. Alternatively, CMOS technologies can be used for lower frequency applications such as sonar and ultrasound and other acoustic applications.

In the Figures, mixer 38 has been shown as a digital mixer preceding D/A converter 50. Mixer 38 could equivalently be an analog mixer following D/A converter 50 and 94. In the case of the single-sideband hybrid bandpass and baseband delta-sigma modulator having an in-phase and quadrature upconverter mixer, D/A converter 50 could multiplex the quadrature Q channel 36 and the in-phase I channel 37 to independently convert each of the feedback Q and I channels into respective analog Q signal components and analog I signal components. The analog Q signal components would be coupled to the quadrature upconverter mixer and the analog I signal component would be coupled to the in-phase upconverter mixer. The outputs of the quadrature and in-phase mixers are summed to produce the real analog feedback signal. Alternatively, D/A converter 50 could be implemented as first and second D/A converter blocks. The first D/A converter block would couple quadrature Q channel 36 to the quadrature upconverter mixer, and the second D/A converter would couple the in-phase I channel 37 to the in-phase upconverter mixer. Again, the two mixers are summed to produce the real analog feedback signal.

**Claims**

1. A delta-sigma modulator (25) comprising:

an input node for receiving an input signal; 21
a feedforward path having a feedforward input and a feedforward output;
a feedback path having a feedback input and a feedback output, said feedforward output being coupled to said feedback input for producing a feedback signal traveling along said feedback path to said feedback output;
a first-delta junction (26) for differencing the signal content of said input node and said feedback output, and coupling the result to said feedforward input, to produce a feedforward signal traveling along said feedforward path to said feedforward output;
said feedforward path having a downconverter mixer (30) and an analog-to-digital converter (ADC) 34, said downconverter mixer being effective for shifting said feedforward signal along the frequency spectrum to a lower carrier frequency, said ADC being effective for digitizing said feedforward signal and placing the result on said feedforward output;
said feedback path having an upconverter mixer (38) and a digital-to-analog converter (DAC) 50, said upconverter mixer being effective for shifting said feedback signal along the frequency spectrum to a higher carrier frequency, said DAC being effective for converting said feedback signal to the analog domain, said upconverter mixer being placed before said DAC in said feedback path.

2. The delta-sigma modulator of claim 1 wherein said delta-sigma modulator is implemented as a continuous-time system.

3. The delta-sigma modulator of claim 1 wherein said delta-sigma modulator is implemented as a discrete-time system.

4. The delta-sigma modulator of claim 1 wherein said feedforward path further includes a signal-shaping filter effective for shaping the noise components of said feedforward signal.

5. The delta-sigma modulator of claim 4 wherein said signal-shaping filter is a low pass filter and is placed after said down converter mixer in said feedforward path.

6. The delta-sigma modulator of claim 1 further including a bandpass filter placed before said downconverter mixer in said feedforward path.

7. The delta-sigma modulator of claim 1 further having a sampling clock for controlling said ADC in said feedforward path, and also having a first local clock for controlling said upconverter mixer in said feedback path, said first local clock having a frequency substantially equal to 1/4 of the frequency of said sampling clock.

8. The delta-sigma modulator of claim 7 further having a second local clock for controlling said downconverter mixer in said feedforward path, said second local clock having a frequency substantially equal to 1/4 of the frequency of said sampling clock.

9. The delta-sigma modulator of claim 1 further having a sampling clock for controlling said DAC in said feedback path and also having a local clock for controlling said ADC in said feedforward path, said local clock having a frequency substantially equal to half of the frequency of said sampling clock.

10. The delta-sigma modulator of claim 1 wherein said downconverter mixer is a single-sideband downconverter producing an in-phase channel and a quadrature channel.

11. The delta-sigma modulator of claim 10 wherein said ADC in said feedforward path includes an in-phase ADC and a quadrature ADC, said in-phase ADC being coupled to said in-phase channel and said quadrature ADC being coupled to said quadrature channel.

12. The delta-sigma modulator of claim 11 wherein said upconverter mixer in said feedback path is a single sideband upconverter having an in-phase upconverter mixer component, a quadrature upconverter mixer component, and a summing node for summing the output of said in-phase and quadrature upconverter mixer components, the output of said in-phase ADC being coupled to the input of said in-phase upconverter mixer component and the output of said quadrature ADC being coupled to the input of said quadrature upconverter mixer component.

13. The delta-sigma modulator of claim 1 further having a second delta junction, a second DAC, and a resonator, said second DAC being coupled to receive said feedback signal from said feedback path, said second delta junction receiving a bandpass input signal and being effective for differencing it with the output of said second DAC, the output of said second delta junction being coupled to said resonator, and said resonator producing said input signal at said input node.

14. The delta-sigma modulator of claim 4, wherein said signal-shaping filter includes a plurality of integrators each having a respective local feedback path from the output of said ADC.

15. The delta-sigma modulator of claim 1 further including a second delta junction node, a noise-shaping filter, and a local DAC, said second delta junction being effective for differencing said feedforward signal with the output of said local DAC, the output of said second delta junction being coupled to said noise-shaping filter, said ADC being effective for quantizing and digitizing the output of said noise-shaping filter, the output of said ADC being coupled to said feedforward output and to the input of said local DAC.

**Revendications**

1. Modulateur delta-sigma (25) comprenant :

un noeud d'entrée destiné à recevoir un signal d'entrée 21,
une ligne de précompensation comportant une entrée de précompensation et une sortie de précompensation,
une ligne de contre-réaction comportant une entrée de contre-réaction et une sortie de contre-réaction, ladite sortie de précompensation étant couplée à ladite entrée de contre-réaction en vue de produire un signal de contre-réaction se déplaçant le long de ladite ligne de contre-réaction vers ladite sortie de contre-réaction,
une première jonction delta (26) destinée à réaliser une différence du contenu de signal dudit noeud d'entrée et de ladite sortie de contre-réaction, et destinée à coupler le résultat à ladite entrée de précompensation, afin de produire un signal de précompensation se déplaçant le long de ladite ligne de précompensation vers ladite sortie de précompensation,
ladite ligne de précompensation comportant un mélangeur de transposition par abaissement de fréquence (30) et un convertisseur analogique vers numérique (ADC) 34, ledit mélangeur de transposition par abaissement de fréquence étant efficace pour décaler ledit signal de précompensation le long du spectre de fréquences vers une fréquence de porteuse plus basse, ledit convertisseur ADC étant efficace en vue de numériser ledit signal de précompensation et placer le résultat sur ladite sortie de précompensation,
ladite ligne de contre-réaction comportant un mélangeur de transposition par élévation de fréquence (38) et un convertisseur numérique vers analogique (DAC) (50), ledit mélangeur de transposition par élévation de fréquence étant efficace en vue de décaler ledit signal de contre-réaction le long du spectre de fréquences vers une fréquence de porteuse plus haute, ledit convertisseur DAC étant efficace en vue de convertir ledit signal de contre-réaction vers le domaine analogique, ledit mélangeur de transposition par élévation de fréquence étant placé avant ledit convertisseur DAC dans ladite ligne de contre-réaction.

2. Modulateur delta-sigma selon la revendication 1, dans lequel ledit modulateur delta-sigma est mis en oeuvre sous la forme d'un système continu dans le temps.

3. Modulateur delta-sigma selon la revendication 1, dans lequel ledit modulateur delta-sigma est mis en oeuvre sous forme d'un système à séparation dans le temps.

4. Modulateur delta-sigma selon la revendication 1, dans lequel ladite ligne de précompensation comprend en outre un filtre de mise en forme de signal efficace en vue de mettre en forme les composantes de bruit dudit signal de précompensation.

5. Modulateur delta-sigma selon la revendication 4, dans lequel ledit filtre de mise en forme de signal est un filtre passe-bas et est placé après ledit mélangeur de transposition par abaissement de fréquence dans ladite ligne de précompensation.

6. Modulateur delta-sigma selon la revendication 1 comprenant en outre un filtre passe-bande placé avant ledit mélangeur de transposition par abaissement de fréquence dans ladite ligne de précompensation.

7. Modulateur delta-sigma selon la revendication 1 comportant en outre une horloge d'échantillonnage en vue de commander ledit convertisseur ADC dans ladite ligne de précompensation, et comportant également une première horloge locale destinée à commander ledit mélangeur de transposition par élévation de fréquence dans ladite ligne de contre-réaction, ladite première horloge locale comportant une fréquence sensiblement égale à 1/4 de la fréquence de ladite horloge d'échantillonnage.

8. Modulateur delta-sigma selon la revendication 7 comportant en outre une seconde horloge locale destinée à commander ledit mélangeur de transposition par abaissement de fréquence dans ladite ligne de précompensation, ladite seconde horloge locale comportant une fréquence sensiblement égale à 1/4 de la fréquence de ladite horloge d'échantillonnage.

9. Modulateur delta-sigma selon la revendication 1 comportant en outre une horloge d'échantillonnage destinée à commander ledit convertisseur DAC dans ladite ligne de contre-réaction et comportant également une horloge locale destinée à commander ledit convertisseur ADC dans ladite ligne de précompensation, ladite horloge locale comportant une fréquence sensiblement égale à la moitié de la fréquence de ladite horloge d'échantillonnage.

10. Modulateur delta-sigma selon la revendication 1, dans lequel le mélangeur de transposition par abaissement de fréquence est un dispositif de transposition par abaissement de fréquence à une seule bande latérale produisant un canal en phase et un canal en quadrature.

11. Modulateur delta-sigma selon la revendication 10, dans lequel ledit convertisseur ADC dans ladite ligne de précompensation comprend un convertisseur ADC en phase, et un convertisseur ADC en quadrature, ledit convertisseur ADC en phase étant couplé audit canal en phase et ledit convertisseur ADC en quadrature étant couplé audit canal en quadrature.

12. Modulateur delta-sigma selon la revendication 11, dans lequel ledit mélangeur de transposition par élévation de fréquence dans ladite ligne de contre-réaction est un dispositif de transposition par élévation de fréquence à une seule bande latérale comportant un composant de mélangeur de transposition par élévation de fréquence en phase, un composant de mélangeur de transposition par élévation de fréquence en quadrature, et un noeud de sommation destiné à sommer la sortie desdites composantes de mélangeur de transposition par élévation de fréquence en phase et en quadrature, la sortie dudit convertisseur ADC en phase étant couplée à l'entrée dudit composant de mélangeur de transposition par élévation de fréquence en phase et la sortie dudit convertisseur ADC en quadrature étant couplée à l'entrée dudit composant de mélangeur de transposition par élévation de fréquence en quadrature.

13. Modulateur delta-sigma selon la revendication 1 comportant en outre une seconde jonction delta, un second convertisseur DAC, et un résonateur, ledit second convertisseur DAC étant couplé pour recevoir ledit signal de contre-réaction provenant de la ligne de contre-réaction, ladite seconde jonction delta recevant un signal d'entrée de bande passante et étant efficace pour réaliser une différence de celui-ci avec la sortie dudit second convertisseur DAC, la sortie de ladite seconde jonction delta étant couplée audit résonateur, et ledit résonateur produisant ledit signal d'entrée au niveau dudit noeud d'entrée.

14. Modulateur delta-sigma selon la revendication 4, dans lequel ledit filtre de mise en forme de signal comprend une pluralité d'intégrateurs comportant chacun une ligne de contre-réaction locale respective depuis la sortie dudit convertisseur ADC.

15. Modulateur delta-sigma selon la revendication 1 comprenant en outre un second noeud de jonction delta, un filtre de mise en forme de bruit, et un convertisseur DAC local, ladite seconde jonction delta étant efficace pour réaliser une différence dudit signal de précompensation avec la sortie dudit convertisseur DAC local, la sortie de ladite seconde jonction delta étant couplée audit filtre de mise en forme de bruit, ledit convertisseur ADC étant efficace en vue de quantifier et numériser la sortie dudit filtre de mise en forme de bruit, la sortie dudit convertisseur ADC étant couplée à ladite sortie de précompensation et à l'entrée dudit convertisseur DAC local.

**Patentansprüche**

1. Delta-Sigma-Modulator (25), umfassend:

einen Eingangsknoten zum Empfangen eines Eingangssignals (21);

einen Vorwärtsregelungsweg mit einem Vorwärtsregelungseingang und einem Vorwärtsregelungsausgang;

einen Rückkopplungsweg mit einem Rückkopplungseingang und einem Rückkopplungsausgang, wobei der Vorwärtsregelungsausgang mit dem Rückkopplungseingang gekoppelt ist, um ein Rückkopplungssignal zu erzeugen, das entlang des Rückkopplungsweges zum Rückkopplungsausgang läuft;

einen ersten Deltaübergang (26) zum Differenzieren des Signalgehalts des Eingangsknotens und des Rückkopplungsausgangs und zum Koppeln des Ergebnisses mit dem Vorwärtsregelungseingang, um ein Vorwärtsregelungssignal zu erzeugen, das entlang des Vorwärtsregelungsweges zum Vorwärtsregelungsausgang läuft;

wobei der Vorwärtsregelungsweg einen Abwärtsmischer (30) und einen Analog-Digital-Wandler (ADC) (34) aufweist, wobei der Abwärtsmischer zum Verschieben des Vorwärtsregelungssignals entlang des Frequenzspektrums zu einer niedrigeren Trägerfrequenz wirksam ist, wobei der ADC zum Digitalisieren des Vorwärtsregelungssignals und Geben des Ergebnisses auf den Vorwärtsregelungssausgang wirksam ist;

wobei der Rückkopplungsweg einen Aufwärtsmischer (38) und einen Digital-Analog-Wandler (DAC) (50) aufweist, wobei der Aufwärtsmischer zum Verschieben des Rückkopplungssignals entlang des Frequenzspektrums zu einer höheren Trägerfrequenz wirksam ist, wobei der DAC zum Umwandeln des Rückkopplungssignals in die analoge Domäne wirksam ist, wobei der Aufwärtsmischer im Rückkopplungsweg vor dem DAC angeordnet ist.

2. Delta-Sigma-Modulator nach Anspruch 1, wobei der Delta-Sigma-Modulator als System mit kontinuierlicher Zeit implementiert wird.

3. Delta-Sigma-Modulator nach Anspruch 1, wobei der Delta-Sigma-Modulator als System mit diskreter Zeit implementiert wird.

4. Delta-Sigma-Modulator nach Anspruch 1, wobei der Vorwärtsregelungsweg ferner ein Signalformungsfilter umfasst, das zum Formen der Rauschkomponenten des Vorwärtsregelungssignals wirksam ist.

5. Delta-Sigma-Modulator nach Anspruch 4, wobei das Signalformungsfilter ein Tiefpassfilter ist und in dem Vorwärtsregelungsweg nach dem Abwärtsmischer angeordnet ist.

6. Delta-Sigma-Modulator nach Anspruch 1, welcher ferner ein Bandpassfilter umfasst, das in dem Vorwärtsregelungsweg vor dem Abwärtsmischer angeordnet ist.

7. Delta-Sigma-Modulator nach Anspruch 1, welcher ferner einen Abtasttakt zum Steuern des ADC in dem Vorwärtsregelungsweg aufweist und auch einen ersten lokalen Takt zum Steuern des Aufwärtsmischers in dem Rückkopplungsweg aufweist, wobei der erste lokale Takt eine Frequenz aufweist, die im Wesentlichen gleich 1/4 der Frequenz des Abtasttakts ist.

8. Delta-Sigma-Modulator nach Anspruch 7, welcher ferner einen zweiten lokalen Takt zum Steuern des Abwärtsmischers in dem Vorwärtsregelungsweg aufweist, wobei der zweite lokale Takt eine Frequenz aufweist, die im Wesentlichen gleich 1/4 der Frequenz des Abtasttakts ist.

9. Delta-Sigma-Modulator nach Anspruch 1, welcher ferner einen Abtasttakt zum Steuern des DAC in dem Rückkopplungsweg aufweist und auch einen lokalen Takt zum Steuern des ADC in dem Vorwärtsregelungsweg aufweist, wobei der lokale Takt eine Frequenz aufweist, die im Wesentlichen gleich der Hälfte der Frequenz des Abtasttakts ist.

10. Delta-Sigma-Modulator nach Anspruch 1, wobei der Abwärtsmischer ein Einseitenband-Abwärtsmischer ist, der einen phasengleichen Kanal und einen Quadraturkanal erzeugt.

11. Delta-Sigma-Modulator nach Anspruch 10, wobei der ADC im Vorwärtsregelungsweg einen phasengleichen ADC und einen Quadratur-ADC umfasst, wobei der phasengleiche ADC mit dem phasengleichen Kanal gekoppelt ist und der Quadratur-ADC mit dem Quadraturkanal gekoppelt ist.

12. Delta-Sigma-Modulator nach Anspruch 11, wobei der Aufwärtsmischer in dem Rückkopplungsweg ein Einseitenband-Aufwärtsmischer mit einer phasengleichen Aufwärtsmischerkomponente, einer Quadratur-Aufwärtsmischerkomponente und einem Summierknoten zum Summieren des Ausgangssignals der phasengleichen und der Quadratur-Aufwärtsmischerkomponente ist, wobei der Ausgang des phasengleichen ADC mit dem Eingang der phasengleichen Aufwärtsmischerkomponente gekoppelt ist und der Ausgangs des Quadratur-ADC mit dem Eingang der Quadratur-Aufwärtsmischerkomponente gekoppelt ist.

13. Delta-Sigma-Modulator nach Anspruch 1, welcher ferner einen zweiten Delta-Übergang, einen zweiten DAC und einen Resonator aufweist, wobei der zweite DAC zum Empfangen des Rückkopplungssignals vom Rückkopplungsweg gekoppelt ist, der zweite Delta-Übergang ein Bandpaß-Eingangssignal empfängt und zum Differenzieren desselben mit dem Ausgangssignal des zweiten DAC wirksam ist, der Ausgang des zweiten Delta-Übergangs mit dem Resonator gekoppelt ist und der Resonator das Eingangssignal am Eingangsknoten erzeugt.

14. Delta-Sigma-Modulator nach Anspruch 4, wobei das Signalformungsfilter eine Vielzahl von Integriergliedern umfaßt, die jeweils einen jeweiligen lokalen Rückkopplungsweg vom Ausgang des ADC aufweisen.

15. Delta-Sigma-Modulator nach Anspruch 1, welcher ferner einen zweiten Delta-Übergangsknoten, ein Rauschformungsfilter und einen lokalen DAC umfaßt, wobei der zweite Delta-Übergang zum Differenzieren des Vorwärtsregelungssignals mit dem Ausgangssignal des lokalen DAC wirksam ist, der Ausgang des zweiten Delta-Übergangs mit dem Rauschformungsfilter gekoppelt ist, der ADC zum Quantisieren und Digitalisieren des Ausgangssignals des Rauschformungsfilters wirksam ist, und der Ausgang des ADC mit dem Vorwärtsregelungsausgang und mit dem Eingang des lokalen DAC gekoppelt ist.

**FIG._1**

12

FIG._2

FIG._3

EP 1 212 838 B1

FIG._4

*FIG._5*

CONTINUOUS-TIME
CIRCUITRY
*316*

DISCRETE-TIME
CIRCUITRY
*317*

RF-
ANALOG
*400*

+
Σ *402*

−

LOOP-
FILTER

*404*

A / D *406*

D / A *410*

*401*

## FIG._6
*(PRIOR ART)*

CONTINUOUS-TIME
CIRCUITRY
*316*

DISCRETE-TIME
CIRCUITRY
*317*

*318*

RF-
ANALOG
*400*

SAMPLE
AND
HOLD

+
Σ *402*

−

LOOP-
FILTER

*404*

A / D *406*

D / A *410*

*401*

## FIG._7
*(PRIOR ART)*

*FIG._8*
(PRIOR ART)

*FIG._9*
(PRIOR ART)

**FIG._10**
**(PRIOR ART)**

**FIG._11**
**(PRIOR ART)**